# EUROPEAN PATENT APPLICATION

(11) **EP 0 536 968 A2**
(43) Date of publication of application: **14.04.1993**
(21) Application number: 92309054.2
(22) Date of filing: 05.10.1992
(51) Int. Cl.: H01L 21/311, H01L 21/90

(54) **Process for forming contact holes in the fabrication of semi-conducteur devices**

(30) Priority: 08.10.1991 JP 260166/91
(71) Applicant: NEC CORPORATION, Tokyo (JP)
(72) Inventor: Nakano, Eiichi, c/o NEC Corporation, Tokyo (JP)
(74) Representative: Moir, Michael Christopher

(57) **Abstract**

Disclosed is a process for producing a semiconductor device, which comprises: depositing an insulator film on one major surface of a semiconductor substrate; and etching said insulator film using a narrow gap system single wafer processing type dry etcher having an electrode-to-electrode distance of 15 mm or less, while the substrate temperature is maintained at 60°C or less. Very fine and deep contact holes having an aspect ratio of more than 1 can be formed in fabricating a multilayer interconnection structure semiconductor device. A 1 µm thick silicon oxide film is allowed to grow as an insulator film 2 by CVD process on a silicon substrate 1, followed by reactive dry etching after masking with a photoresist 3. In this process, 30 sccm of CF₄, 30 sccm of CHF₃ and 120 sccm of Ar are introduced to the reaction chamber in which the electrode-to-electrode distance is set to a narrow gap of 10 mm, and the total pressure is controlled to 300 mtorr. By carrying out the dry etching, while a high frequency is applied at a power density of 5W/cm² across the electrodes in the reaction chamber and the temperature of the silicon substrate 1 is controlled to 55°C, a contact hole having a taper angle controlled to 75° can be formed with a protective film 4 formed on the side wall thereof.

## Description

### BACKGROUND OF THE INVENTION

This invention relates to a process for producing a semiconductor device, more particularly to a process for forming contact holes in insulator films in fabricating a multilayer interconnection structure semiconductor device.

An RIE system dry etcher is generally used for forming contact holes in the insulator films. When such contact holes are formed, a photoresist applied as a masking material on a silicon oxide film is etched together with the silicon oxide film during the process of dry etching to accelerate regression of the mask edge so as to control the profile of the finished contact hole.

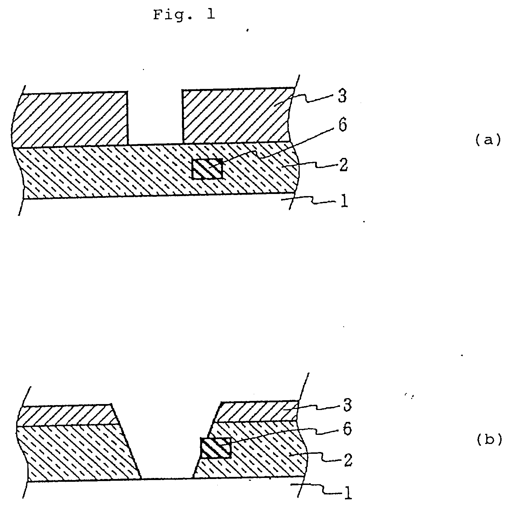

In this process, however, the upper opening of the contact hole formed in the insulator film 2 will inevitably be greater than the original size of the opening of the masking, as shown in Figs. 1(a) and 1(b). In a very fine multilayer interconnection structure, the distance between a lower layer interconnection 6 and the contact hole becomes narrow, or in some extreme cases, the lower layer interconnection 6 will be exposed to cause short circuit.

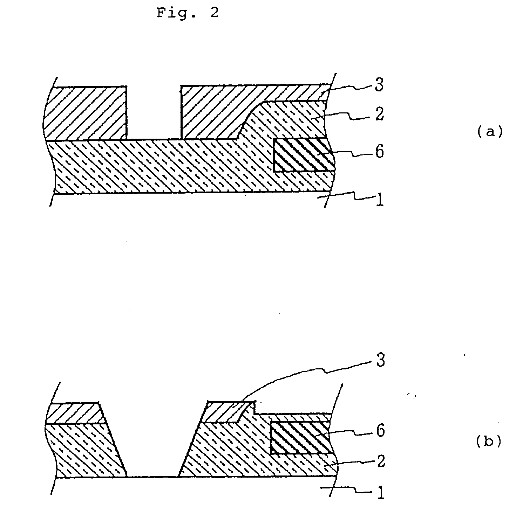

When the surface of an insulator film 2 has large steps, the photoresist 3 applied thereon will be etched off completely at the thin portion as etching proceeds to allow the insulator film 2 to be attacked directly, as shown in Figs. 2(a) and 2(b). Thus, it is difficult to secure necessary thickness in the photoresist masking at the raised portions of the insulator film 2 due to the presence of lower layer inter-connections 6.

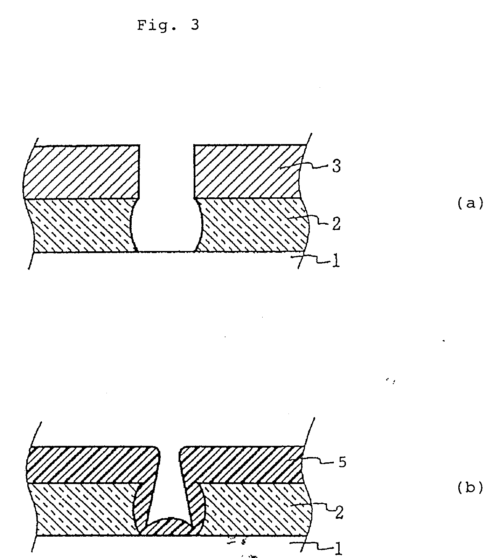

Meanwhile, when a narrow gap system dry etcher is employed, etching is carried out under a pressure of 1 to 2 torr, at a substrate temperature of 80°C and with an Ar partial pressure of 80 to 90% so as to secure a constant etching speed and to improve etch uniformity. As shown in Figs. 3(a) and 3(b), no effective protective film 4 can be formed on the side wall of a very fine and deep contact hole having an aspect ratio of more than 1, and the contact hole formed in the insulator film 2 comes to have a barrel-like profile, as shown in Fig. 3(a), making step coverage of the upper layer interconnection 5 very poor, as shown in Fig. 3(b).

As described above, it has been difficult to form very fine and deep contact holes having an aspect ratio of more than 1 in fabricating a multilayer interconnection structure semiconductor device.

Accordingly, it is an object of this invention to provide a dry etching process for forming a fine and deep contact hole having a controlled tapered profile.

The process for producing a semiconductor device according to this invention includes in one aspect depositing an insulator film on a major surface of a semiconductor substrate and etching a contact hole in said insulator film using a narrow gap dry etcher in an etching gas at a reduced pressure and at a reduced substrate temperature such that a protective film is formed from constituents of the etching gas on the walls of the contact hole to control the profile thereof.

By "reduced pressure" and "reduced substrate temperature" we mean a pressure and a substrate temperature less than hitherto employed in narrow gap dry etching of contact holes.

In another aspect the process according to the invention includes a step of depositing an insulator film on one major surface of a semiconductor substrate and a step of etching the insulator film using a narrow gap system single wafer processing type dry etcher having an electrode-to-electrode distance of 15 mm or less while the substrate temperature is maintained at 60°C or less.

### BRIEF DESCRIPTION OF THE DRAWINGS

The features of this invention that are believed to be novel are set for with particularity in the appended claims. The invention, together with the objects and advantages thereof, may best be understood by reference to the following description of a preferred embodiment taken in conjunction with the accompanying drawings in which:
Fig. 1 shows in cross section how a contact hole is formed according to a conventional technique;
Fig. 2 also shows in cross section how a contact hole is formed according to the conventional technique;
Fig. 3 shows in cross section how a contact hole and inter-connection are formed according to another conventional technique; and
Fig. 4 shows in cross section how a contact hole is formed according to one embodiment of the process of this invention.

### DETAILED DESCRIPTION OF PREFERRED EMBODIMENT

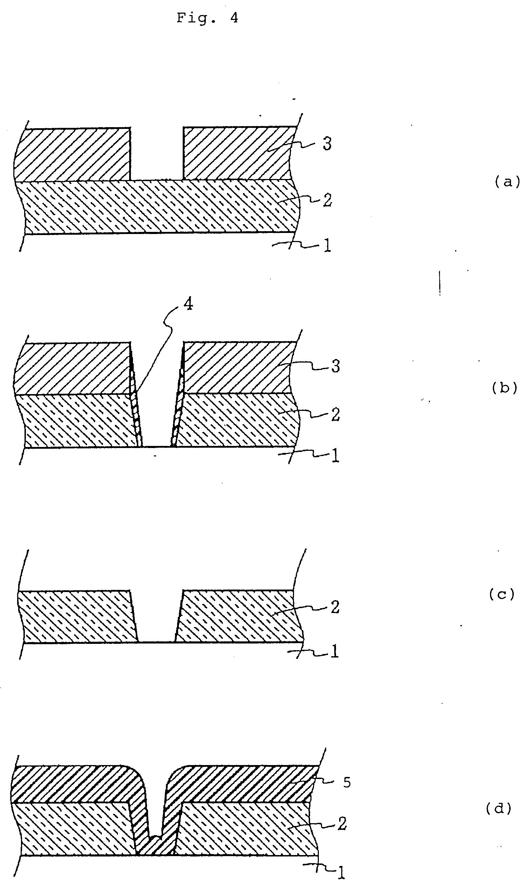

A preferred embodiment of the process of this invention will be described below referring to Figs. 4(a) to 4(d). However, the present embodiment is to be considered as illustrative and not restrictive, and the invention is not to be limited to the details given herein, but may be modified within the scope of the appended claims.

First, a 1 µm thick silicon oxide film was allowed to grow as an insulator film 2 by CVD process on a silicon substrate 1 having been subjected to diffusion treatment, followed by patterning of a photoresist 3, as shown in Fig. 4(a).

Next, the insulator film 2 was etched by reactive dry etching to form a contact hole having a controlled taper angle of 75° with a protective film 4 formed on the side wall thereof, as shown in Fig. 4(b).

In this process, 30 sccm of CF₄, 30 sccm of CHF₃ and 120 sccm of Ar were introduced to the reaction chamber in which the electrode-to-electrode distance was set so as to provide a narrow gap of 10 mm, and the total pressure was controlled to 300 mtorr. The dry etching was carried out, while a high frequency was applied at a power density of 5 W/cm² across the electrodes in the reaction chamber and the temperature of the silicon substrate 1 was controlled to 55°C.

Such setting of the electrodes to a narrow gap confines the plasma discharge zone between the plate electrodes to give a high density plasma, enabling anisotropic etching and high-speed etching, thus improving the etching speed of the single wafer processing type etcher.

CF₄ and CHF₃ generate reactive ions and also radicals which serve as the raw materials of the protective film 4, whereas Ar serves to accelerate the etching reaction on the reaction surface and to suppress the reaction of forming the protective film. When an Ar flow rate of more than 90 % was used, no protective film 4 effective to control the profile of the contact hole was formed. Therefore, an Ar flow rate of 90 % or less was used in this embodiment in order to enhance the efficiency of forming the protective film 4 on the reaction surface.

The mean free path of the reactive ions which are the species to be etched and that of the radicals which are the raw materials of the protective film 4 are elongated by setting the total pressure to a low level of 300 mtorr, whereby the etching at the side wall of the contact hole by scattering of the reactive ions was reduced to promote formation of the protective film 4. No protective film 4 necessary for controlling the profile of a small contact hole 4 having a diameter of 0.6 µm or less was formed under a pressure of 600 mtorr or more.

By keeping the temperature of the silicon substrate 1 at 55°C, the efficiency of forming the protective film 4 by a surface reaction can be improved. When the silicon substrate 1 was maintained at a temperature of 85°C or more under the gaseous condition according to this invention, no protective film 4 sufficient to effectively control the profile of the contact hole was formed.

Next, as shown in Fig. 4(c), the photoresist 3 and the protective film 4 formed on the side wall of the contact hole were removed by oxygen plasma ashing, solvent stripping or acid treatment.

Subsequently, an interconnection of an Al alloy 5 was formed, as shown in Fig. 4(d). Thus, an upper layer inter-connection of excellent step coverage was completed. 30 % of the thickness of the interconnection at the flat portion can be secured even on the side wall of the narrow contact hole.

At least one fluorocarbon such as CF₄, CHF₃, C₂F₆ and C₃F₈ or hydrogen-substituted fluorocarbons can be used, in combination with argon, instead of the CF₄ and CHF₃ gases employed in this embodiment.

According to this invention, etching is carried out at a low substrate temperature and under a low etching gas pressure using the narrow gap system single wafer processing type dry etcher. A contact hole controlled to have a normal taper can be formed while a protective film is formed on the side wall thereof, improving interconnection reliability on a great margin.

Since the present process brings about no regression of the masking material, the margin between the interconnections need not be increased advantageously.

## Claims

1. A process for producing a semiconductor device which comprises depositing an insulator film on a major surface of a semiconductor substrate and etching a contact hole in said insulator film using a narrow gap dry etcher in an etching gas at a reduced pressure and at a reduced substrate temperature such that a protective film is formed from constituents of the etching gas on the walls of the contact hole to control the profile thereof.

2. A process for producing a semiconductor device which comprises:
depositing an insulator film on one major surface of a semiconductor substrate; and
etching said insulator film using a narrow gap system single wafer processing type dry etcher having an electrode-to-electrode distance of 15 mm or less, while the substrate temperature is maintained at 60°C or less.

3. The proccess according to Claim 1 or 2, wherein said insulator film is etched using an etching gas prepared by admixing Ar with at least one selected from fluorocarbons and hydrogen-substituted fluorocarbons.

4. The process according to any preceding claim, wherein said insulator film is etched while the etching gas pressure is maintained at 600 mtorr or less.

5. The process according to any preceding claim, wherein said insulator film is etched while the partial pressure of Ar is maintained at 90% or less.
